# EUROPEAN PATENT APPLICATION

(11) **EP 4 535 409 A1**
(43) Date of publication of application: **09.04.2025**
(21) Application number: 24203267.0
(22) Date of filing: 27.09.2024
(51) Int. Cl.: H01L 21/677

(54) **WAFER CASSETTE LOADING AND UNLOADING SYSTEM FOR AN EPITAXIAL REACTOR AND AN EPITAXIAL REACTOR**

(30) Priority: 02.10.2023 IT 202300020256
(71) Applicant: LPE S.p.A., 20021 Baranzate (MI) (IT)
(72) Inventor: COREA, Francesco, 20021 Baranzate (Milano) (IT); MESCHIA, Maurilio Giuseppe, 20021 Baranzate (Milano) (IT)
(74) Representative: Di Biase, Fabio

(57) **Abstract**

A system (1) for loading and unloading wafer (3) cassettes (2) for an epitaxial reactor (4), the system (1) includes a carousel platform (5), configured to transport at least one cassette (2), wherein the carousel platform (5) is pivotally able to be connected to the epitaxial reactor (4) around a carousel axis (7); a carousel actuator (6), configured to drive the rotation of the carousel platform (5) around the carousel axis (7) in relation to the epitaxial reactor (4); at least one support platform (8), suitable to support at least one cassette (2), wherein at least one support platform (8) is pivotally connected to the carousel platform (5) around a rotation axis (9) that differs from the carousel axis (7); a rotation actuator (10), configured to drive the rotation of at least one support platform (8) around the rotation axis (9) relative to the carousel platform (5).

## Description

### Field of Invention

The present invention relates to a wafer cassette loading and unloading system for an epitaxial reactor, and an epitaxial reactor comprising such a loading and unloading system.

### State of the Art

Wafers intended to undergo epitaxial deposition processing of semiconductor material are generally stored and transported within cassettes, in which the wafers are stacked horizontally and spaced apart from each other.

These cassettes generally include a front side, accessible externally for loading and unloading wafers from the cassette, and an opposite totally or at least partially enclosed rear side.

They are known to inventors of epitaxial reactors equipped with wafer cassette loading and unloading systems.

These loading and unloading systems known to the inventors include a platform pivotally hinged to a shaft, onto which at least one wafer cassette can be loaded.

The platform is pivotable between a first operating position, where the platform faces outwards from the epitaxial reactor so that the wafer cassette can be loaded or unloaded from the outside, and a second operating position, in which the platform faces inward towards the epitaxial reactor so that the wafers contained in the cassette can be manipulated by automated components of the epitaxial reactor, such as a handling robot.

It is well known to inventors that at least two wafer cassettes can be loaded onto the platform, adjacent to each other, so that the wafers contained in one cassette are intended to be used for test processes or tests, while the wafers contained in the other cassette are instead intended for final processing.

A wafer cassette loading and unloading system like this is difficult to interface with an automated loading and unloading system, such as an SMIF or AGV system. In particular, it is complex or impractical to load and unload a second wafer cassette adjacent to a first wafer cassette. Therefore, this loading and unloading system requires manual loading and unloading of wafer cassettes by operators.

Additionally, the loading and unloading system for wafer cassettes of this type requires that the front side of the wafer cassette faces the operator during loading and unloading. However, exposing the front side of the wafer cassette to the operator is undesirable because it increases the risk of wafer contamination or the risk of dropped and damaged wafers.

Therefore, there is a need for a wafer cassette loading and unloading system that can be easily interfaced with automated loading and unloading systems, such as an SMIF or AGV system, or that can also be used manually.

There is also a need for a wafer cassette loading and unloading system that simplifies the loading and unloading of one or more wafer cassettes.

There is also a need to have a wafer cassette loading and unloading system that minimizes the risk of contamination or damage to wafers that are to be subjected or have already been subjected to epitaxial deposition processing.

### Solution

The purpose of the present invention is to provide a wafer cassette loading and unloading system for an epitaxial reactor, and an epitaxial reactor including the loading and unloading system, so that at least some of the problems highlighted in the prior art are solved.

A particular purpose of the present invention is to provide a wafer cassette loading and unloading system for an epitaxial reactor, and an epitaxial reactor comprising the loading and unloading system, which can be easily interfaced with automated loading and unloading systems, or which can also be operated manually.

A further particular object of the present invention is to provide a wafer cassette loading and unloading system for an epitaxial reactor, and an epitaxial reactor comprising the loading and unloading system, which simplifies loading and unloading of one or more wafer cassettes.

A further particular purpose of the present invention is to provide a wafer cassette loading and unloading system for an epitaxial reactor, and an epitaxial reactor comprising the loading and unloading system, which minimizes the risk of contamination or damage to wafers to be subjected or that have already been subjected to epitaxial deposition processing.

A further particular purpose of the present invention is to provide a wafer cassette loading and unloading system for an epitaxial reactor and an epitaxial reactor, comprising a loading and unloading system, which has a small footprint and reduced complexity, and also allows wafer cassettes to be transported closer to an epitaxial reactor handling robot, thus avoiding unwanted stresses on the handling robot.

This and other purposes are achieved by a wafer cassette loading and unloading system for an epitaxial reactor, and an epitaxial reactor comprising the loading and unloading system, according to the independent claims.

The dependent claims relate to preferred and advantageous implementations of the present invention.

### Figures

To better understand the invention and appreciate its advantages, some of its illustrative and non-limiting forms of implementation will be described below, referencing the accompanying figures, wherein:

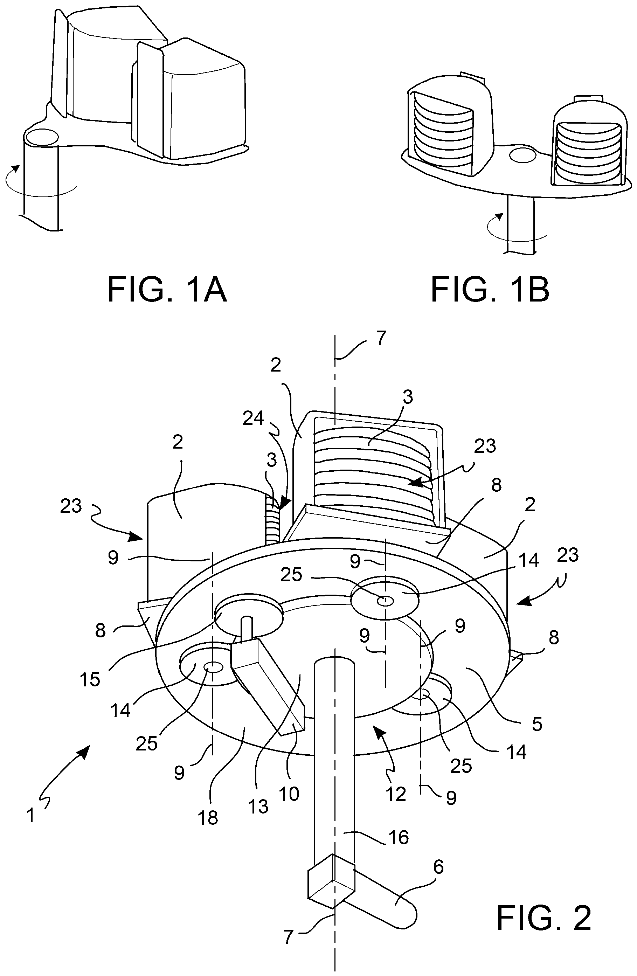

- Figures 1A and 1B are schematic perspective views of a wafer cassette loading and unloading system, in a first and second operating position, according to the state of the art known to the inventors;
- Figure 2 is a schematic perspective lower view of a wafer cassette loading and unloading system, according to one form of implementation of the invention;

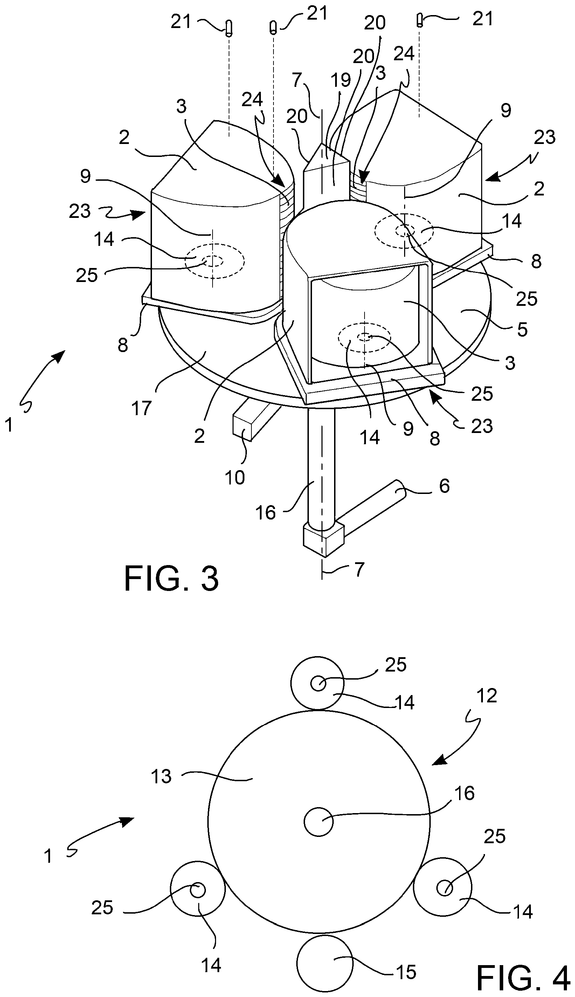

- Figure 3 is a schematic perspective top view of the wafer cassette loading and unloading system depicted in Figure 2;
- Figure 4 is a schematic view of a cross-section of the wafer cassette loading and unloading system depicted in Figure 2;

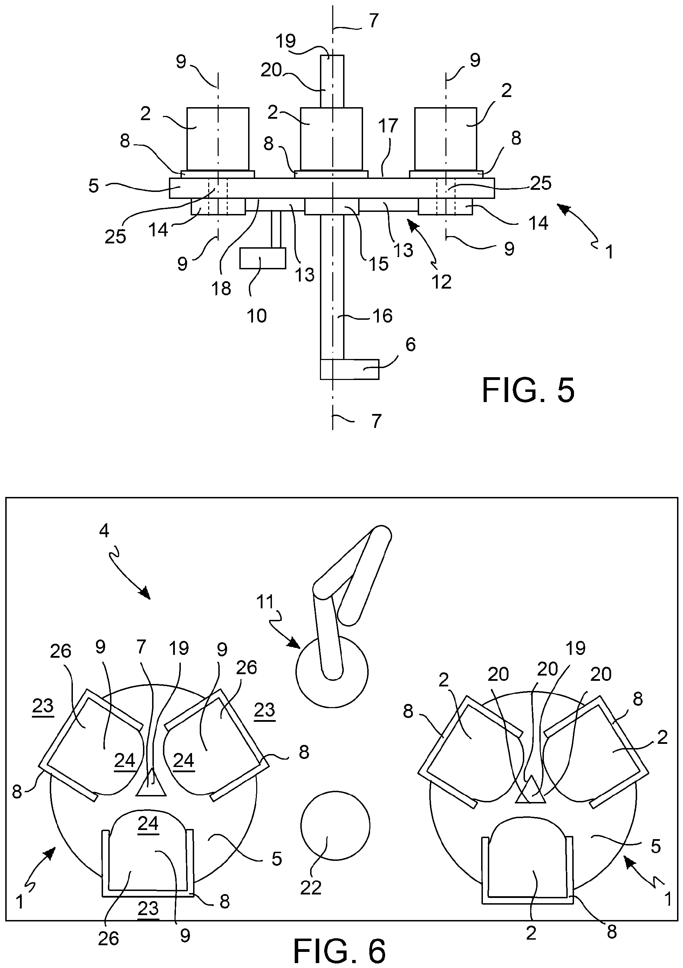

- Figure 5 is a schematic side view of the wafer cassette loading and unloading system depicted in Figure 2;
- Figure 6 is a schematic top view of a portion of an epitaxial reactor, according to one form of implementation of the invention.

### Description of some preferred examples implemented

With reference to the figures, a wafer cassette loading and unloading system is generally indicated with the reference number 1.

The loading and unloading system 1 is configured to enable the loading and unloading of wafer 3 cassettes 2 into an epitaxial reactor 4.

Generally, cassettes 2 include a front side 23, accessible from the outside for the loading and unloading of wafers 3 from cassette 2, and an opposite rear side 24 at least partially closed.

The system 1 comprises a carousel platform 5, configured to transport at least one cassette 2.

The carousel platform 5 is pivotally able to be connected to the epitaxial reactor 4 around a carousel axis 7.

The carousel axis 7 is substantially transverse to the carousel platform 5.

The system 1 also includes a carousel actuator 6.

The carousel actuator 6 is configured to drive a rotation of the carousel platform 5 around the carousel axis 7. Specifically, the carousel actuator 6 is configured to operate a rotation of the carousel platform 5 in relation to the epitaxial reactor 4, around the carousel axis 7.

In this way, the carousel platform 5 is capable of transporting at least one wafer 3 cassette 2 from a first operating position to a second operating position, via the rotation of at least one cassette 2 around the carousel axis 7. Specifically, the first operating position may correspond to a position where the cassette 2 can be loaded or unloaded from the epitaxial reactor 4 in an automated or manual manner. The second operating position may correspond to a position where the wafers 3 from the cassette 2 are able to be moved by automatic components of the epitaxial reactor 4, such as a handling robot 11.

Rotation of the carousel platform 5 with respect to the epitaxial reactor 4 refers specifically to the rotation of the carousel platform 5 relative to a fixed frame of the epitaxial reactor 4.

According to one aspect of the invention, the system 1 also includes at least one support platform 8, adapted to support at least one wafer 3 cassette 2.

In particular, the support platform 8 is adapted to support a single cassette 2 out of the one or more cassettes 2 that can be transported by the carousel platform 5.

At least one support platform 8 is pivotally connected to the carousel platform 5 around a rotation axis 9.

The rotation axis 9 is distinct from the carousel axis 7.

The rotation axis 9 is essentially parallel to the carousel axis 7.

Furthermore, the system 1 includes a rotation actuator 10.

The rotation actuator 10 is configured to operate a rotation of at least one support platform 8 around the rotation axis 9. Specifically, the rotation actuator 10 is configured to operate a rotation of at least one support platform 8 in relation to the carousel platform 5, around the rotation axis 9.

Advantageously, a system 1 configured in this way enables easy loading and unloading of one or more wafer 3 cassettes 2, either by automated systems such as SMIF or AGV or manually. In fact, a system 1 configured in this way allows one or more cassettes 2 to be loaded or unloaded in an essentially identical first operating position for each cassette 2 and conveniently able to be positioned for automated or manual loading, thus simplifying loading and unloading operations.

With an additional advantage, the system 1 configured in this way minimizes the risk of contamination or damage to wafers 3 contained in one or more cassettes 2, as it does not require the front side 23 of the cassettes 2 to be exposed towards the operator during loading and unloading operations on the system 1. In fact, the system 1 allows the cassette 2 to be loaded or unloaded on the support platform 8 with the rear side 24 of cassette 2 facing the operator. Subsequently, when the cassette 2 is, for example, placed in the second operating position, the system 1 enables, via the rotation of the support platform 8 supporting the cassette 2 around the rotation axis 9, the rotation of the cassette 2 and thus exposing the front side 23 of the cassette 2 towards the inside of the epitaxial reactor 4, for example towards a handling robot 11 that is able to handle wafers 3 in the cassette 2.

With an additional advantage, the system 1 thus configured, compared to the state of the art systems known to the inventors, also allows the wafer 3 cassettes 2 to be moved closer to a handling robot 11 in the epitaxial reactor 4, thus avoiding unwanted stresses on the handling robot 11.

According to one implementation form, the system 1 includes a gear mechanism 12.

The gear 12 connects the rotation actuator 10 to at least one support platform 8.

The gear 12 is configured to rotate the support platform 8 relative to the carousel platform 5, around the rotation axis 9.

According to one implementation form, the system 1 comprises a motion transmission system connecting the rotation actuator 10 with at least one support platform 8, which may include drive chains and/or timing belts and/or mechanical couplings.

According to one implementation form, the system 1 includes a sprocket 13.

The sprocket 13 is pivotally connected to the carousel platform 5.

Furthermore, the sprocket 13 is positioned coaxially to the carousel axis 7. In this way, the sprocket 13 can be pivoted relative to the carousel platform 5, around the carousel axis 7.

The system 1 also includes at least one drive wheel 14.

At least one drive wheel 14 is attached to a respective support platform 8. Furthermore, the drive wheel 14 is positioned coaxially to the rotation axis 9.

The drive wheel 14 is engaged with the sprocket 13.

Furthermore, the rotation actuator 10 is operatively connected to the sprocket 13, in order to activate a rotation of the sprocket 13 around the carousel axis 7 relative to the carousel platform 5.

Advantageously, configuring the system 1 in this manner allows the cassettes 2 to be transported from a first operating position to a second operating position by a rotation of the carousel platform 5. Furthermore, with the sprocket 13 and the drive wheel 14 configured in this manner and geared together, the cassette 2 is able to be rotated so as to expose its front 23 or rear, as required.

By way of example, the wafer 3 cassette 2 is able to be loaded on the support platform 8, in a first operating position, with the rear side 24 of the cassette 2 facing an operator or automated system. Subsequently, the cassette 2 is able to be transported from the first operating position to a second operating position by the rotation of the carousel platform 5, to which the support platform 8 is connected, relative to the epitaxial reactor 4 around the carousel axis 7, driven by the carousel actuator 6. While traveling between the first and second operating positions, or at the second operating position, the cassette 2 is able to pivot on itself so as to expose its front side 23 towards a handling robot 11 in the epitaxial reactor 4, by a rotation of the support platform 8 around the rotation axis 9 in relation to the carousel platform 5, driven by the rotation actuator 10, and in particular performed via a rotation of the drive wheel 14, integral to the support platform 8, driven by a rotation of the sprocket 13 to which the drive wheel 14 is geared.

According to one form of implementation, the sprocket 13 and at least one drive wheel 14 are essentially placed in a coplanar position.

According to one form of implementation, at least one drive wheel 14 is geared externally to the sprocket 13, with reference to the carousel axis 7.

According to one form of implementation, at least one drive wheel 14 is geared internally to the sprocket 13, with reference to the carousel axis 7.

According to one form of implementation, the rotation actuator 10 comprises a drive gear 15.

The drive gear 15 is engaged with the sprocket 13. The drive gear 15 is configured to command a rotation of the sprocket 13 around the carousel axis 7.

According to one form of implementation, the sprocket 13, at least one drive wheel 14 and the drive gear 15 are essentially placed in a coplanar position.

According to one form of implementation, at least one drive gear 15 is externally engaged with the sprocket 13, in reference to the carousel axis 7.

According to one form of implementation, at least one drive gear 15 is internally engaged with the sprocket 13, in reference to the carousel axis 7.

According to one form of implementation, the sprocket 13, at least one drive wheel 14 and, when provided, the drive gear 15, have either cylindrical or helical teeth.

According to one form of implementation, the system 1 comprises a shaft 16.

The shaft 16 is attached to the carousel platform 5.

Furthermore, the shaft 16 extends along the carousel axis 7, essentially coaxially to the carousel axis 7.

The shaft 16 is interposed between the carousel actuator 6 and the carousel platform 5.

Specifically, the shaft 16 is configured to receive a rotary motion from the carousel actuator 6 and transmit the rotary motion to the carousel platform 5, so as to drive the rotation of the carousel platform 5 around the carousel axis 7.

According to one form of implementation, the shaft 16 extends passing through the sprocket 13.

According to one form of implementation, the shaft 16 is positioned opposite the support platforms 8, in relation to the carousel platform 5.

According to one form of implementation, each support platform 8 comprises a respective rotation shaft 25. The rotation shaft 25 extends coaxially to the respective rotation axis 9.

The rotation shaft 25 is attached to the support platform 8 and a respective drive wheel 14.

According to one form of implementation, the rotation shaft 25 extends through the carousel platform 5. In this way, the rotation shaft 25 integrally connects the support platform 8 to the respective drive wheel 14, positioned opposite one another with respect to the carousel platform 5.

According to one form of implementation, the carousel actuator 6 is a servomotor.

According to one form of implementation, the carousel actuator 6 is connected to one end of the shaft 16 opposite to one end of the shaft 16 to which the carousel platform 5 is connected.

According to one form of implementation, the rotation actuator 10 is a servomotor.

According to one form of implementation, the carousel platform 5 is a plate, for example circular in shape and coaxial to the carousel axis 7.

According to one form of implementation, the support platform 8 is a plate. According to one form of implementation, the support platform 8 is a plate that is circular or prism shaped or essentially shaped to reflect the shape of a lower wall of the cassettes 2.

According to one form of implementation, at least one support platform 8 is positioned opposite the sprocket 13 and at least one drive wheel 14, relative to the carousel platform 5.

According to one form of implementation, the system 1 comprises a plurality of support platforms 8 pivotally connected to the carousel platform 5 around the respective and distinct rotational axes 9.

The respective rotation axes 9 are parallel to each other and parallel to the carousel axis 7.

According to one form of implementation, the system 1 comprises three support platforms 8.

Advantageously, one of the three support platforms 8 may be intended to support and transport a wafer 3 cassette 2 for testing procedures or tests, another of the three support platforms 8 may be intended to support and transport a wafer 3 cassette 2 to be subjected to final processes in an epitaxial reactor reaction chamber 4, and another of the three support platforms 8 may be intended to support and transport a wafer 3 cassette 2 into an epitaxial reactor reaction chamber 4. Therefore, a system 1 configured in this way can be used in epitaxial reactors 4 having more than one reaction chamber, and allows for a quick and easy replenishment or withdrawal of wafers 3 to be processed or treated.

According to one form of implementation, the support platforms 8 are positioned angularly equidistant to each other on the carousel platform 5.

According to one form of implementation, the three support platforms 8 are positioned essentially equidistant 120° from each other on the carousel platform 5.

According to one form of implementation, the respective drive wheels 14 of the plurality of support platforms 8 are engaged with the same sprocket 13.

Advantageously, this configuration allows the rotation of all support platforms 8 to be driven by the rotation of the gear wheel 13 alone, to which the drive wheels 14 connected to the respective support platforms 8 are geared.

According to one form of implementation, the carousel platform 5 comprises a top wall 17 and an opposite lower wall 18.

The top wall 17 of the carousel platform 5 faces at least one support platform 8. Specifically, the support platforms 8 are positioned above the top wall 17 of the carousel platform 5.

The lower wall 18 of the carousel platform 5 faces the sprocket 12. According to one form of implementation, the lower wall 18 is also facing at least one drive wheel 14, the drive gear 15 and the shaft 16.

According to one form of implementation, the system 1 comprises a reflector element 19.

The reflector element 19 comprises at least one reflective surface 20.

According to one form of implementation, the reflective surface 20 is essentially positioned parallel to the carousel axis 7.

Advantageously, the reflector element 19 is adapted to reflect a laser beam from the epitaxial reactor 4, for example emitted by the handling robot 11, and used to detect wafers 3 contained in the cassette 2 supported by the support platform 8. For example, the laser beam emitted by the handling robot 11 may be reflected by the reflector 19 in the direction of the partially open rear side 24 of the cassette 2, so as to detect the number and placement of the wafers 3 contained in the cassette 2.

According to one form of implementation, the reflector element 19 includes a number of reflective surfaces 20 equal to the number of support platforms 8 connected to the same carousel platform 5.

According to one form of implementation, each reflective surface 20 is extended over a plane parallel to the carousel axis 7.

According to one form of implementation, each reflective surface 20 is positioned in line with a respective support platform 8, facing the respective support platform 8.

According to one form of implementation, each reflective surface is positioned between the carousel axis 7 and a support platform 8.

According to the form of implementation in which the system includes three support platforms 8, the reflector element 19 comprises three reflective surfaces 20 positioned parallel to the carousel axis 7 and arranged essentially in the shape of an equilateral triangle.

According to the form of implementation in which the carousel platform 5 is a circular plate, each reflective surface 20 is positioned parallel to the carousel axis 7 and transverse to a radial axis of the carousel platform 5.

According to one form of implementation, the reflector element 19 includes a support that is suitable for supporting the one or more reflective surfaces 20.

According to one form of implementation, the reflector element 19 is positioned at the top wall 17 of the carousel platform 5.

According to one form of implementation, the reflector element 19 is positioned at the carousel axis 7.

According to one form of implementation, the reflector element 19 is positioned essentially concentrically with the carousel axis 7.

According to one form of implementation, the reflector element 19 is connected to the top wall 17 of the carousel platform 5.

According to one form of implementation, the reflector element 19 extends along the carousel axis 7 opposite to the lower wall 18 of the carousel platform 5.

According to one form of implementation, the carousel actuator 6 and the rotation actuator 10 are positioned opposite the support platforms 8 relative to the carousel platform 5.

According to one form of implementation, the carousel actuator 6 and the rotation actuator 10 are positioned below the lower wall 18, comprised within the vertically occupied footprint, i.e., in the direction of the carousel axis 7, relative to the carousel platform 5.

According to one form of implementation, the system 1 includes a detection system 21.

The detection system 21 is configured to detect the positioning and orientation of one or more support platforms 8, or one or more cassettes 2 supported by the respective support platforms 8, relative to the carousel platform 5.

Advantageously, by means of the detection system 21 it is possible to check that the cassettes 2, supported by the support platforms 8, are correctly oriented during the handling and transportation phases of the cassettes. By way of example, the detection system 21 can detect whether the cassette 2 is correctly positioned with the front side 23 of the cassette 2 facing the handling robot 11 when cassette 2 is in the second operating position, or that cassette 2 is correctly positioned with the back side 24 of the cassette 2 facing the operator when the cassette 2 is in the first operating position.

According to one form of implementation, the detection system 21 comprises at least one detection device, such as a laser sensor or an image detector.

According to one form of implementation, one or more detection devices are positioned above one or more support platforms 8, in relation to the carousel platform 5, facing the support platforms 8.

According to an additional form of implementation, one or more detection devices are positioned in line with the top wall 17 of the carousel platform 5, facing the support platforms 8.

According to a further aspect of the invention, an epitaxial reactor 4 comprises at least one reaction chamber.

Wafers 3 can be inserted inside the reaction chamber to undergo epitaxial deposition processing of semiconductor material.

The epitaxial reactor 4 also includes at least one loading and unloading system 1 of wafer 3 cassettes 2 as previously described.

According to one form of implementation, the reactor 4 includes a handling robot 11.

The handling robot 11 is configured to move the wafers 3 contained in the respective cassettes 2.

Furthermore, the handling robot 11 is configured to handle the wafer carriers contained in the respective carrier cassettes 26.

According to one form of implementation, the epitaxial reactor 4 comprises at least two systems 1. According to one form of implementation, the epitaxial reactor 4 comprises at least two reaction chambers.

According to one form of implementation, the epitaxial reactor 4 comprises two reaction chambers and two systems 1.

Advantageously, one of the two systems 1 can be used to handle cassettes 2 of wafers 3 to be subjected or that have been subjected to epitaxial deposition processing, while
the other of the two systems 1 can be used to handle cassettes for supports 26 containing wafer holders.

According to one form of implementation, the handling robot 11 is positioned essentially interposed between two systems 1.

According to one form of implementation, the epitaxial reactor 4 comprises a loading station 22 or "Centering Unit (CU)".

According to one form of implementation, the loading station 22 is positioned at the handling robot 11.

According to one form of implementation, the loading station 22 is positioned interposed between two systems 1.

Advantageously, in an epitaxial reactor 4 configured in this manner, the handling robot 11 is capable of picking up a wafer holder from a respective support cassette 26 of a first system 1, and placing the wafer holder on the loading station 22. Subsequently, the handling robot 11 is able to pick up a wafer 3 from a respective cassette 2 of a second system 1, and place the wafer 3 on the wafer holder previously placed on the loading station 22. In this way, the wafer supported by the wafer holder is able to be moved by the handling robot 11 and can be transported in the direction of the one or more epitaxial reactor 4 reaction chambers.

According to one form of implementation, the epitaxial reactor 4 comprises a single system 1.

According to one form of implementation, the epitaxial reactor 4 comprises two reaction chambers and a single system 1.

According to one form of implementation, the handling robot 11 is positioned in line with the system 1.

According to one form of implementation, the handling robot 11 is positioned between the two reaction chambers.

According to one form of implementation, the loading station 22 is positioned in line with the handling robot 11 and the system 1.

Advantageously, in an epitaxial reactor 4 configured in this way, the cassettes 2 for wafers 3 and cassettes for supports 26 are able to be loaded on the same system 1. The handling robot 11 is then able to pick up a wafer holder from a respective support cassette 26 in the system 1, and place the wafer holder on the loading station 22. The handling robot is then able to pick up a wafer 3 from a respective cassette 2 from the same system 1, and place the wafer 3 on the wafer holder previously placed on the loading station 22. With an additional advantage, this configuration reduces the footprints of the epitaxial reactor 4.

Of course, the person skilled in the art will be able to make modifications or adaptations to the present invention, without departing from the scope of the claims set forth below.

### REFERENCES

1. Wafer cassette loading and unloading system
2. Cassette
3. Wafer
4. Epitaxial reactor
5. Carousel platform
6. Carousel actuator
7. Carousel axis
8. Support platform
9. Rotation axis
10. Rotation actuator
11. Handling robot
12. Gear
13. Sprocket
14. Drive wheel
15. Drive gear
16. Shaft
17. Top wall of the carousel platform
18. Lower wall of the carousel platform
19. Reflector element
20. Reflective surface
21. Detection system
22. Loading station
23. Front side of the cassette
24. Rear side of the cassette
25. Rotation shaft
26. Support cassette

## Claims

1. A system (1) for the loading and unloading of wafer (3) cassettes (2) for an epitaxial reactor (4), the system (1) comprising:
- a carousel platform (5), configured to transport at least one cassette (2), wherein the carousel platform (5) is pivotally able to be connected to the epitaxial reactor (4) around a carousel axis (7);
- a carousel actuator (6), configured to drive a rotation of the carousel platform (5) around the carousel axis (7) relative to the epitaxial reactor (4);
**characterized by the fact of** understanding:
- at least one support platform (8), adapted to support at least one cassette (2), wherein at least one support platform (8) is pivotally connected to the carousel platform (5) around a rotation axis (9) that differs from the carousel axis (7);
- a rotation actuator (10), configured to operate a rotation of at least one support platform (8) around the rotation axis (9) in relation to the carousel platform (5).

2. The system (1) according to claim 1, comprising a gear (12) connecting the rotation actuator (10) with at least one support platform (8), wherein the gear (12) is configured to rotate the support platform (8) relative to the carousel platform (5), around the rotation axis (9).

3. The system (1) according to claim 1 or 2, comprising a sprocket (13) pivotally connected to the carousel platform (5), wherein the sprocket (13) is positioned coaxially to the carousel axis (7),
wherein the system (1) includes at least one drive wheel (14) attached to at least one support platform (8), wherein the drive wheel (14) is positioned coaxially to the rotation axis (9), and wherein the drive wheel (14) is engaged with the sprocket (13),
and wherein the rotation actuator (10) is operatively connected to the sprocket (13), so as to drive a rotation of the sprocket (13) around the carousel axis (7) relative to the carousel platform (5),
and wherein, optionally, at least one drive wheel (14) is geared externally to the sprocket (13), with reference to the carousel axis (7).

4. The system (1) according to claim 3, wherein the rotation actuator (10) comprises a drive gear (15) engaged with the sprocket (13),
wherein the drive gear (15) is configured to operate a rotation of the sprocket (13) around the carousel axis (7),
and wherein, optionally, the sprocket (13), at least one drive wheel (14) and the drive gear (15) are essentially placed in a coplanar position,
and wherein, optionally, the drive gear (15) is geared externally to the sprocket (13), with reference to the carousel axis (7),
and wherein, optionally, the sprocket (13), at least one drive wheel (14) and the drive gear (15) have cylindrical or helical teeth.

5. A system (1) according to any preceding claim, comprising a shaft (16) attached to the carousel platform (5) and extended along the carousel axis (7), coaxially to the carousel axis (7),
wherein the shaft (16) is interposed between the carousel actuator (6) and the carousel platform (5), and wherein the shaft (16) is configured to receive a rotary motion from the carousel actuator (6) and transmit the rotary motion to the carousel platform (5), so as to drive the rotation of the carousel platform (5) around the carousel axis (7),
and wherein the shaft (16) is extended through a sprocket (13),
and wherein, optionally, the shaft (16) is positioned opposite the support platforms (8), relative to the carousel platform (5).

6. The system (1) according to claim 3 or 4, wherein each support platform (8) comprises a respective rotation shaft (25) extended coaxially to the respective rotation axis (9), wherein the rotation shaft (25) is attached to the support platform (8) and a respective drive wheel (14),
and wherein the rotation shaft (25) extends through the carousel platform (5).

7. The system (1) according to any preceding claim, wherein the carousel actuator (6) is a servomotor,
and/or wherein the rotation actuator (10) is a servomotor.

8. The system (1) according to any preceding claim, comprising three support platforms (8) rotationally connected to the carousel platform (5) around respective and distinct rotation axes (9),
wherein the respective rotational axes (9) are parallel to each other and parallel to the carousel axis (7),
wherein, optionally, the support platforms (8) are positioned angularly equidistant with each other on the carousel platform (5),
wherein, optionally, respective drive wheels (14) of the plurality of support platforms (8) are geared to the same sprocket (13),
in which, optionally, the carousel platform (5) is a plate circular in shape and coaxial to the carousel axis (7), and the support platform (8) is a plate,
and wherein, optionally, at least one support platform (8) is positioned opposite a sprocket (13) and a drive wheel (14), in relation to the carousel platform (5).

9. The system (1) according to any preceding claim, wherein the carousel platform (5) comprises a top wall (17) and an opposite lower wall (18), wherein the top wall (17) of the carousel platform (5) faces at least one support platform (8),
wherein the system (1) includes a reflector element (19) comprising at least one reflective surface (20) positioned essentially parallel to the carousel axis (7),
wherein the reflector element (19) is connected to the top wall (17) of the carousel platform (5), at the carousel axis (7), and wherein the reflector element (19) extends along the carousel axis (7) opposite the lower wall (18) of the carousel platform (5), wherein, optionally, the reflector (19) includes a number of reflective surfaces (20) equal to the number of support platforms (8) connected to the same carousel platform (5), wherein, optionally, each reflective surface (20) is extended on a plane parallel to the carousel axis (7) and is positioned in line with a respective support platform (8), overlooking the respective support platform (8).

10. The system (1) according to any of the preceding claims, including a detection system (21) configured to detect the positioning and orientation of the one or more support platforms (8), or the one or more cassettes (2) supported by respective support platforms (8), in relation to the carousel platform (5),
and wherein, optionally, the detection system (21) includes one or more detection devices positioned above one or more support platforms (8), in relation to the carousel platform (5), facing the support platforms (8),
and wherein, optionally, the detection devices are laser sensors or image detectors.

11. An epitaxial reactor (4), comprising at least one reaction chamber and at least one wafer (3) cassette (2) loading and unloading system (1) according to any one of the previous claims,
and, optionally, wherein the epitaxial reactor (4) includes a handling robot (11) configured to handle the wafers (3) contained in the respective cassettes (2).

12. An epitaxial reactor (4), according to claim 11, comprising at least two reaction chambers and at least two systems (1) according to one of claims 1 to 10,
wherein the epitaxial reactor (4) comprises a handling robot (11) positioned essentially between the two systems (1),
and wherein the epitaxial reactor (4) comprises a loading station (22) positioned by the handling robot (11), interposed between the two systems (1).

13. An epitaxial reactor (4), according to claim 11, including at least two reaction chambers and a single system (1) according to one of claims 1 to 10,
wherein the epitaxial reactor (4) includes a handling robot (11) positioned by the system (1),
and wherein the epitaxial reactor (4) comprises a loading station (22) positioned by the handling robot (11) and the system (1).
